# EUROPEAN PATENT APPLICATION

(11) **EP 4 734 690 A1**
(43) Date of publication of application: **29.04.2026**
(21) Application number: 24208256.8
(22) Date of filing: 23.10.2024
(51) Int. Cl.: H05K 9/00, H02B 1/30

(54) **CABLE ENTRY DEVICE FOR ELECTRICAL ENCLOSURES**

(71) Applicant: Siemens Gamesa Renewable Energy A/S, 7330 Brande (DK)
(72) Inventor: Sethu, Maniarasan, 7400 Herning (DK); Rasmussen, Brian, 7323 Give (DK)
(74) Representative: SGRE-Association

(57) **Abstract**

The invention refers to a cable entry device for supporting and positioning cables entering into an electrical cabinet or enclosure, preferably with electromagnetic compatibility, EMC, features. The cable entry comprises a plate formed as a unitary body having: a first section provided with means for attaching the device to an external structure, a second section adjacent to the first section and provided with means for mounting electromagnetic shielded cable supports, and a third section adjacent the second section, such that the second section is interposed in between the first and second sections, and wherein the third section is provided with a plurality of notches for clamping cables.

## Description

### TECHNICAL FIELD

The present invention refers in general to cables handling in electrical enclosures.

In a wind turbine there is electrical parts and cabinets including means for different electrical cables. For such electrical devices, and cabinets, the IP (international protection) standard on sealing of enclosures and EMC (electromagnetic compatibility) screening should, if so required, be attainable for equipment cabinets by the simplest and most effective means possible.

The invention thus refers to a cable entry device for supporting and positioning cables entering into an electrical cabinet or enclosure, preferably with electromagnetic compatibility, EMC, features.

An object of the invention is the provision of a cable entry device, which is: cost-effective, modular, versatile, and ease of use, and which can be used in a wide variety of cabinets and control panels.

Existing cable entries are often expensive and too complicated for the desired function.

### DESCRIPTION OF THE INVENTION

The invention is defined in the attached independent claim, and satisfactorily solves the above-described drawbacks of the prior art, by the provision of a cable entry featuring a cost-effective and straightforward solution to address Electromagnetic Compatibility, EMC, cable entry requirements.

In particular a first aspect of the invention refers to a cable entry device for electrical enclosures, wherein the device comprises a plate formed as a body having: a first section provided with means for attaching the device to an external structure, a second section provided with means for mounting electromagnetic shielded cable supports, and a third section provided with a plurality of means for holding the cables.

The plate may be formed as a body making it easy and cheap to manufacture.

The first and third sections section each may be positioned adjacent the second section, such that the second section is interposed between the first and third sections. This makes it easy to manufacture in a simple step, e.g. if the device is a unitary body, the first and third sections then easily can be formed at longitudinal end sections body.

The first, second and third sections may thus extend longitudinally in the plate.
The means for holding the cables may be formed as notches for clamping the cables thus fixing them. This again makes an easy producible and cheap solution.

The plate may be conformed as an elongated and L-shaped body, preferably made of metal, wherein the first section is angled with respect to the second and third sections, preferably the first and second sections forms a 90° angle.

The means for attaching the device to an external structure, may comprise openings for the passage of bolts or screws.

The means for mounting electromagnetic shielded cable supports in the second section, may be formed by two parallel rows of passing-though openings, wherein the openings are equidistantly distributed in each row.

In a preferred embodiment of the invention, a part of the third section including the notches, may be inclined downwards with respect to the second section. Preferably, the notches extend from an edge of the plate so that the notches are accessible through that edge.

Preferably, the cable entry may be fitted with electromagnetic shielded cable supports, such as EMC shielding clamps of at least two different sizes, mounted in the second section of the plate.

Another aspect of the invention refers to an electrical cabinet incorporating at least one cable entry device as the one previously defined, wherein the first section of the plate is attached to a wall or structural member of the electrical cabinet, and incorporating cables supported by the electromagnetic shielded cable supports, and clamped in the notches of the third section.

The claimed cable entry device provides a modular design, which ensures versatility by allowing the use of various cable sizes within the same device. In addition, the cable entry device can be installed in a broad variety of (standard) cabinets and control panels. Moreover, the simplicity of production and ease of assembly, streamlines the process of mounting cables effectively. Furthermore, it provides strain relief as it prevents any undue strain caused by the cables' self-weight, the cables are thus properly supported and protected against any potential mechanical stresses.

### BRIEF DESCRIPTION OF THE DRAWINGS

To complete the description and in order to provide a better understanding of the invention, a set of drawings is provided. These drawings form an integral part of the description and illustrate embodiments of the invention, which should not be interpreted as restricting the scope of the invention, but just as examples of how the invention can be carried out. The drawings comprise the following figures:
- Figures 1 and 2: show two perspective views of a cable entry device according to the invention.
- Figure 3: shows an electrical cabinet incorporating several cable entry devices.

### PREFERRED EMBODIMENTS OF THE INVENTION

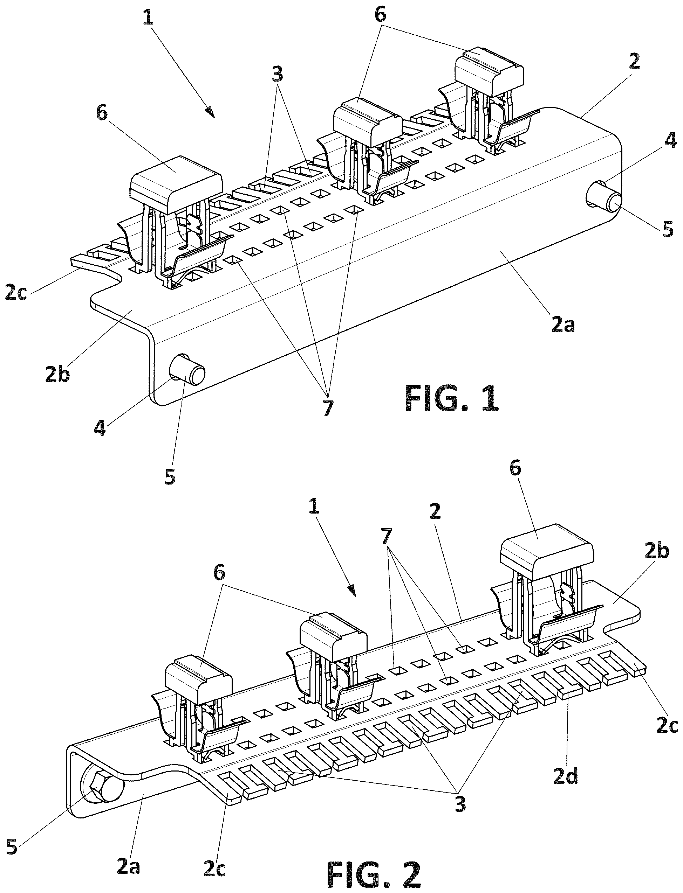

As represented in **Figures 1** and **2****,** the cable entry device (1) may be formed as a body (2) extending in a longitudinal direction, and formed with three sections, namely: a first section (2a) provided with means for attaching the device (1) to an external structure, a second section (2b) provided with means for mounting electromagnetic shielded cable supports (6), and a third section (2c) provided with a plurality of means (3) for holding cables.

In an example, the cable entry device may be made of metal.

As illustrated in the example embodiment of the figures, the device (1) may be formed as a unitary body may be realized as a bent elongated metal plate (2), the first section (2a) being bent relative to the second section (2b), and / or the third section (2c) being bent relative to the second section (2b). This makes it easy and chap to manufacture the device (1) .

In one embodiment the respective first (2a) and third (2c) sections each are bent relative to second section (2b) at the same angle, or at two different angles.

In one embodiment the first (2a), second (2b) and third (2c) sections extends along the longitudinal direction of the device (1), or the plate (2). The sections may be essentially parallel to each other.

The second section (2b) may be positioned adjacent to the first section (2a) and provided with means (7) for mounting electromagnetic shielded cable supports (6), and the third section (2c) may be positioned adjacent the second section (2b) and provided with means (3) for holding cables. The second section (2b) in this embodiment thus may be interposed in between the first and second sections (2a, 2c), and wherein the third section (2c) is provided with a plurality of means (3) for holding cables, such as notches (3) as illustrated.

In the embodiment shown in the figures, the first section (2a) and the second section (2a) together may for an essential L-shape, such as defining a 90° angle.

The means (4) provided in the second section (2a) for attaching the device (1) to an external structure such as a cabinet or control panel, comprises fixation means, such as clamps or openings (4) for the passage of bolts (5).

In the illustrated embodiment, the means (7) provided in the second section (2b) for mounting electromagnetic shielded cable supports (6), are formed by two parallel rows of passing-though openings (7), wherein the openings are equidistantly distributed in each row. The size of the openings (7) and the relative separation distance between them, allow for the coupling of mounting electromagnetic shielded cable supports (6) of different sizes.

Other means (7) could also apply to the present invention, e.g. a plural of camping means fixed on the surface of the first section (2a).

The means (7) as illustrated may be positioned in an array, or in parallel rows, as illustrated, or in any other suitable organization.

In either embodiment, either the means (7) or the cable supports (6) comprises means able to detach the cable supports (6) from the means (7) and hence the first section (2a) .

In one embodiment the means (3) for holding cables are formed as notices (3), or recesses, formed in an edge part of the third section (2c). Alternatively, they could e.g. be clamping means formed in an edge part of the third section (2c) or attached thereto. The means (3) for holding the cables may extend at a direction away from the first section (2a), such as at an angle to the longitudinal direction of the device (1), e.g. essentially perpendicular.

In more general terms, the means (3) for holding cables are positioned at the third section (2c) and formed such, that during mounting of the cables, if they have electromagnetic shielded cable supports (6) positioned at their ends, then the cable supports (6) need not to be mounted through any openings of any cable holding means, but can easily be mounted in a simple manner, e.g. first connecting the cable supports (6) to passing-though openings (7) and then fixing the cable, e.g. by pushing, or squeezing, the cables into the means (3) for holding cables, possible fare formed as notices (3). This can be done in a simple movement and manner, e.g. using only one hand. Naturally the order of actions can be reversed or done essentially simultaneously.

In the same manner, if the cable supports (6) is mounted on the first section (2a) before connected to the cables, the cables then easily can be fixed to the cable supports (6) and the means (3) for holding the cables.

The means (3) for holding cables then are positioned such that it eases this mounting and ensures relatively little bending of the cables.

In one embodiment the third section (2c) is bent in a direction away from the surface of the first section (2a) whereto the electromagnetic shielded cable supports (6) is to be mounted.

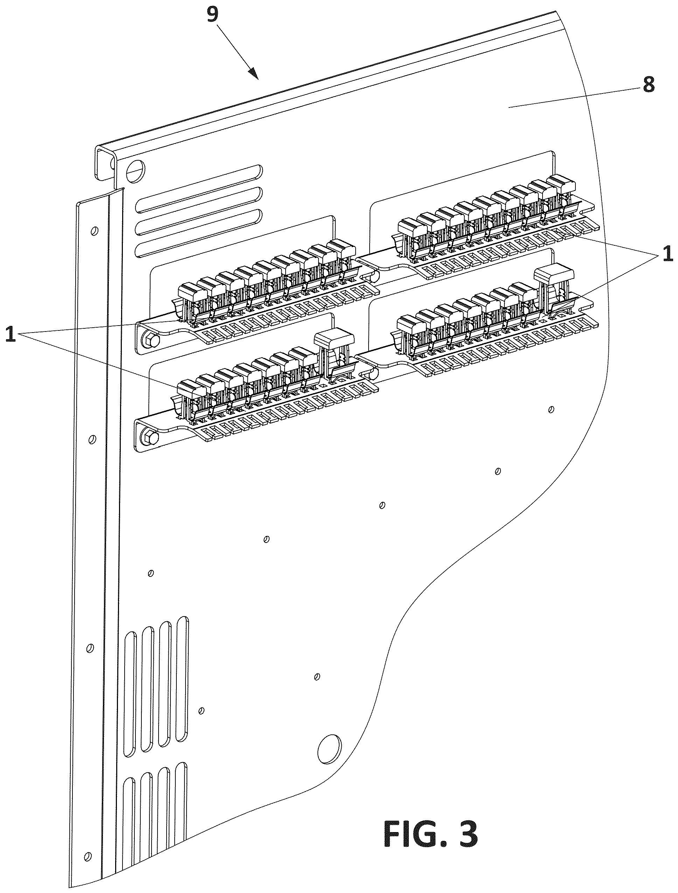

In one embodiment the second (2b) and third (2c) sections are bent in the same direction relative to the first section (2a), but at different angles. The third section (2c) may be bent at a smaller angle than the second section (2b) making it easier to access the means (3) for holding the cables when the devices (1) are attached to an electrical cabinet (9) as illustrated in figure 3.

A part of the third section (3c) including the notches (3) thus may be inclined downwards with respect to the second section (2b), when the device (1) is the position shown in **Figure 2****,** that is, with the first section (2a) placed vertically. The notches (3) extend from an edge (2d) of the plate (2), that is, the notches (3) are open at the edge (2d) for the passage of cables (not shown) clamped in the cable supports (6).

As it can be noted in the figures, the third section (2c) and a part of the second section (2b) closest to the third section (2c), are shorter than the first section (2a) and the rest of the second section (2b), and the openings (4) and bolts (5), are located at the ends of the first section (2a). This feature has the advantage that the bolts (5) are easily accessible from the front of the device (1), which facilitates installation of the same.

**Figure 3** shows several devices (1) as the one show in the previous figures, attached to a wall (8) of an electrical cabinet (9). In practice, cables would be supported and retained by the electromagnetic shielded cable supports (6), and clamped in the notches (3) of the device (1).

The solution with the devices (1) makes a cheap and scalable solution. Standardized devices (1) and electromagnetic shielded cable supports (6) can be manufactured in large numbers, and given the number of cables to be mounted, more devices (1) then quickly can be fixed to the cabinet (9). Further, it is easy to remove and replace devices (1), cable supports (6) and/or cables.

## Claims

1. Cable entry device (1) for electrical enclosures,
the device (1) comprising a plate (2) formed as a body having:
a first section (1a) provided with means for attaching the device (1) to an external structure,
a second section (2b) provided with means (7) for mounting electromagnetic shielded cable supports (6), and
a third section (2c) provided with a plurality of means (3) for holding cables.

2. Cable entry device (1) according to claim 1, where the plate (2) is formed as a unitary body.

3. Cable entry device (1) according to claim 1 or 2, wherein the first (2a) and third (2c) sections section each positioned adjacent the second section (2b), such that the second section (2b) is interposed between the first (2a) and third (2c) sections

4. Cable entry device (1) according to claim 1, 2 or 3, wherein the means (3) for holding the cables are formed as notches (3) for clamping the cables.

5. Cable entry device according (1) to any of the preceding claims, confitured as an elongated and L-shaped body, wherein the first section (2a) is angled with respect to the second and third sections (2b, 2c).

6. Cable entry device (1) according to claim 5, wherein the first and second sections (2a, 2b) form a 90° angle.

7. Cable entry device (1) according to claim 5, wherein the first, second and third sections (2a, 2b, and 2c) extend longitudinally in the plate (2).

8. Cable entry device (1) according to any of the preceding claims, wherein the means for attaching the device to an external structure, comprise openings (4) for the passage of bolts or screws (5).

9. Cable entry device (1) according to any of the preceding claims, wherein the means for mounting electromagnetic shielded cable supports (6) in the second section (2b), are formed by two parallel rows of passing-though openings (7), wherein the openings are equidistantly distributed in each row.

10. Cable entry device (1) according to any of the preceding claims, wherein a part of the third section (2c) including the notches (3), is inclined with respect to the second section (2b).

11. Cable entry device (1) according to any of the preceding claims, wherein the notches (3) extend from an edge of the plate (2).

12. Cable entry device (1) according to any of the preceding claims, wherein the plate (2) is made of metal.

13. Cable entry device (1) according to any of the preceding claims, comprising electromagnetic shielded cable supports (6) mounted in the second section (2b) of the plate (2).

14. Cable entry device (1) according to claim 13, comprising electromagnetic shielded cable supports (6) of at least two different sizes.

15. Electrical cabinet (9) incorporating at least one cable entry device (1) according to any if the preceding claims , and wherein the first section (2a) of each device (1) is attached to a wall (8) or structural member of the electrical cabinet (9), and comprising cables supported by the electromagnetic shielded cable supports (6) of at least one of the devices (1), and clamped in the means (3) for holding cables of the third section (2c).
